# EUROPÄISCHE PATENTSCHRIFT

(11) **EP 1 927 433 B1**
(45) Veröffentlichungstag und Bekanntmachung des Hinweises auf die Patenterteilung: **01.04.2009**
(21) Anmeldenummer: 07022053.8
(22) Anmeldetag: 13.11.2007
(51) Int. Cl.: B24B 37/04, H01L 21/677, H01L 21/683

(54) **Vorrichtung zum Trennen von zwei aufeinander angeordneten scheibenförmigen Elementen bei der Entnahme**
Device for separating two disc-shaped elements positioned one above the other when removing one
Dispositif de séparation de deux éléments circulaires agencés l'un sur l'autre lors de l'extraction

(30) Priorität: 29.11.2006 DE 102006056339
(43) Veröffentlichungstag der Anmeldung: 04.06.2008
(73) Patentinhaber: Brain, Bernhard, 86368 Gersthofen (DE)
(72) Erfinder: Brain, Bernhard, 86368 Gersthofen (DE)
(74) Vertreter: Beder, Jens

(56) Entgegenhaltungen:
- EP-A- 1 232 835
- DE-A1- 10 007 389

## Beschreibung

Die Erfindung betrifft eine Vorrichtung zum Trennen von zwei aufeinander angeordneten scheibenförmigen Elementen bei der Entnahme der scheibenförmigen Elemente aus einem Trägerelement.

Bei der Bearbeitung von scheibenförmigen Elementen wie beispielsweise Halbleiterscheiben, ist es häufig erforderlich, aus einer Transporteinrichtung, wie beispielsweise einer Kassette, scheibenförmige Elemente zu entnehmen und einem Verarbeitungsprozess zuzuführen. Hierzu werden die in einer Kassette zugeführten Elemente in einem Trägerelement abgelegt. Die in dem Trägerelement abgelegten Elemente werden dann durch Transportieren des Trägerelements dem eigentlichen Verarbeitungsprozess zugeführt.

Aus der DE 100 07 389 A1 ist eine Vorrichtung zur Entnahme von Halbleiterscheiben aus einem solchen Trägerelement bekannt. Das Trägerelement ist dabei so beschaffen, dass eine beidseitige Bearbeitung der Oberflächen der Halbleiterscheiben erfolgen kann. Zwar ist damit bereits die Bearbeitung eines in einem Trägerelement angeordneten scheibenförmigen Elements sowohl auf der Oberseite als auch auf der Unterseite bekannt, es ist jedoch mit der dort vorgestellten Vorrichtung nicht möglich, gleichzeitig jeweils eine Oberfläche von zwei verschiedenen scheibenförmigen Elementen zu bearbeiten. Zwar ließe das Trägerelement, welches aus der DE 100 07 389 A1 bekannt ist, die Bearbeitung von jeweils einer Oberfläche bei zwei aufeinanderliegenden Halbleiterscheiben zu. Allerdings ist die Entnahme der Halbleiterscheiben mit der aus der DE 100 07 389 A1 bekannten Vorrichtung nicht möglich. Insbesondere würde die Entnahme der oberen Halbleiterscheibe mit einem Saugkopf unter Umständen zu einem Herausheben beider Halbleiterscheiben führen, da diese aufgrund des dazwischen ausgebildeten Vakuums aneinander haften.

Es ist daher die Aufgabe der Erfindung, eine Vorrichtung zum Trennen zweier aufeinander angeordneter scheibenförmiger Elemente bei der Entnahme der scheibenförmigen Elemente aus dem Trägerelement zu schaffen.

Die Aufgabe wird durch die erfindungsgemäße Vorrichtung mit den Merkmalen des Anspruchs 1 gelöst.

Die erfindungsgemäße Vorrichtung zum Trennen von zwei aufeinander angeordneten scheibenförmigen Elementen bei der Entnahme der scheibenförmigen Elemente aus einem Trägerelement weist zumindest eine Hebevorrichtung zum Abheben eines ersten, oberen scheibenförmigen Elements sowie eine Haltevorrichtung zum Halten eines zweiten, unteren scheibenförmigen Elements auf. Die Hebevorrichtung ist dabei so eingerichtet, dass sie eine erste Unterdruckkraft an einer ersten Oberfläche des ersten scheibenförmigen Elements erzeugt. Entsprechend ist die Haltevorrichtung so ausgebildet, dass sie eine zweite Unterdruckkraft an einer zweiten Oberfläche des zweiten scheibenförmigen Elements erzeugt. Die beiden scheibenförmigen Elemente sind so in dem Trägerelement angeordnet, dass die erste Oberfläche des ersten scheibenförmigen Elements und die zweite Oberfläche des zweiten scheibenförmigen Elements in voneinander abgewandte Richtungen weisen. Die Hebevorrichtung und die Haltevorrichtung sind so ausgebildet, dass die erste Unterdruckkraft mit einer ersten Kraftverteilung und zweite Unterdruckkraft mit einer zweiten Kraftverteilung an der ersten Oberfläche des ersten scheibenförmigen Elements bzw. der zweiten Oberfläche des zweiten scheibenförmigen Elements angreifen, wobei die erste und die zweite Kraftverteilung sich voneinander unterscheiden.

Bei einer solchen unterschiedlichen Kraftverteilung der ersten Unterdruckkraft und der zweiten Unterdruckkraft wird gewährleistet, dass anders als bei sich entsprechender Kraftverteilung an den Oberflächen des ersten scheibenförmigen Elements und des zweiten scheibenförmigen Elements die Ausbildung eines Vakuums zwischen den beiden scheibenförmigen Elementen verhindert oder zumindest stark reduziert wird. Aufgrund dieser starken Reduzierung des Vakuums zwischen den beiden scheibenförmigen Elementen können die Kräfte, die zum Abheben des ersten scheibenförmigen Elements von dem zweiten scheibenförmigen Element erforderlich sind, stark reduziert werden. In Folge dessen sinkt die Beschädigungsquote der scheibenförmigen Elemente. Eine weitere Reduzierung des erzeugten Ausschuss wird ferner dadurch erreicht, dass sowohl das erste scheibenförmige Element als auch das zweite scheibenförmige Element jeweils über eine erste bzw. zweite Unterdruckkraft abgehoben bzw. gehalten werden. Ein Fassen oder Halten der scheibenförmigen Elemente an ihrem äußeren Umfangsrand ist daher nicht erforderlich.

Insbesondere sofern es sich bei den scheibenförmigen Elementen um sog. Wafer handelt, ist die Erzeugung der Halte- oder Hebekräfte mittels Unterdruck vorteilhaft, da die spröden Silizium-Wafer, welche derzeit bis hinab zu Dicken von 50 µm hergestellt werden, relativ spröde sind.

In den Unteransprüchen sind vorteilhafte Weiterbildungen der erfindungsgemäßen Vorrichtung ausgeführt.

Insbesondere ist es vorteilhaft, dass die Hebevorrichtung und die Haltevorrichtung unterschiedliche Anzahlen von Saugelementen umfassen. Im Zusammenhang mit der vorliegenden Erfindung wird unter dem Begriff "Saugelement" jedes Element verstanden, welches in der Lage ist, an einer Oberfläche eine Unterdruckkraft zu erzeugen. Eine solche Unterdruckkraft kann auch dann erzeugt werden, wenn aus dem Saugelement ein Fluid ausströmt, wie es beispielsweise bei sog. Bernoulli-Saugelementen der Fall ist. Zumindest ein Bernoulli-Saugelement wird vorzugsweise für die Hebevorrichtung eingesetzt.

Gemäß einer weiteren bevorzugten Ausführungsform weist die Haltevorrichtung zumindest ein Vakuum-Element auf. Der Einsatz eines Vakuum-Elements bei der Haltevorrichtung hat den Vorteil, dass im Gegensatz zur Verwendung von Bernoulli-Saugelementen lediglich ein sehr geringer Oberflächenbereich der Oberfläche des scheibenförmigen Elements zum Erzeugen der Kraft erforderlich ist. Damit wird auch für scheibenförmige Elemente, bei denen aufgrund der Dimensionierung des Bernoulli-Saugers an der gegenüberliegenden Fläche nur noch ein geringer Flächenanteil zur Positionierung der Haltevorrichtung verfügbar ist, ein sicheres Zurückhalten des zweiten scheibenförmigen Elements erreicht.

Gemäß einer weiteren bevorzugten Ausführungsform ist die Hebevorrichtung so eingerichtet, dass die erste Unterdruckkraft in einem inneren Bereich des ersten scheibenförmigen Elements erzeugt wird, und die Haltevorrichtung so eingerichtet, dass die zweite Unterdruckkraft in einem äußeren Bereich des zweiten scheibenförmigen Elements erzeugt wird. Gemäß einer weiteren bevorzugten Ausführungsform ist umgekehrt die Hebevorrichtung so eingerichtet, dass die erste Unterdruckkraft in einem äußeren Bereich des ersten scheibenförmigen Elements erzeugt wird, und die Haltevorrichtung ist so eingerichtet, dass die zweite Unterdruckkraft in einem inneren Bereich des zweiten scheibenförmigen Elements erzeugt wird. Durch diese beiden bevorzugten Ausführungsformen wird gewährleistet, dass jeweils eines der beiden scheibenförmigen Elemente eine Unterdruckkraft etwa im Bereich der Flächenmitte erfährt. Das jeweils andere scheibenförmige Element wird dagegen näher zu seinem Rand mit einer Unterdruckkraft beaufschlagt. Dadurch wird verhindert, dass die beiden scheibenförmigen Elemente sich in ihrem äußeren Bereich nahe ihres Außenumfangs so aneinander anlegen, dass eine die beiden Elemente voneinander abhebende Kraft zur Erzeugung eines Vakuums zwischen den beiden Elementen führt. Würden beispielsweise zwei einfache Vakuum- oder Bernoulli-Sauger eingesetzt, welche jeweils in der Mitte der voneinander abgewandten Flächen der scheibenförmigen Elemente eine Unterdruckkraft erzeugen, so würden sich im Bereich der Flächenmitte die beiden scheibenförmigen Elemente voneinander abheben. Dadurch entsteht zwischen den beiden scheibenförmigen Elementen ein Vakuum, welches die Trennung der beiden scheibenförmigen Elemente voneinander verhindert oder zumindest erhebliche Kräfte zum Trennen erforderlich macht. Um eine sichere Trennung durchzuführen, wäre dann die Erhöhung der auf die Oberflächen wirkenden Unterdruckkräfte erforderlich, was zur Beschädigung der scheibenförmigen Elemente führen kann. Dies wird erfindungsgemäß dadurch verhindert, dass auf das erste scheibenförmige Element eine erste Unterdruckkraft mit einer ersten Kraftverteilung wirkt und auf das zweite scheibenförmige Element eine zweite Unterdruckkraft mit einer zweiten Kraftverteilung wirkt. Die erste Kraftverteilung und die zweite Kraftverteilung unterscheiden sich dabei voneinander, so dass dem Entstehen eines Vakuums zwischen den beiden scheibenförmigen Elementen entgegengewirkt wird.

Ein bevorzugtes Ausführungsbeispiel der erfindungsgemäßen Vorrichtung ist in der Zeichnung dargestellt und wird in der nachfolgenden Beschreibung näher erläutert. Es zeigen:
- Fig. 1: eine schematische Darstellung einer erfindungsgemäßen Vorrichtung in einer Draufsicht; und
- Fig. 2: eine zweite schematische Darstellung eines Ausschnitts der erfindungsgemäßen Vorrichtung entlang der Linie II-II.

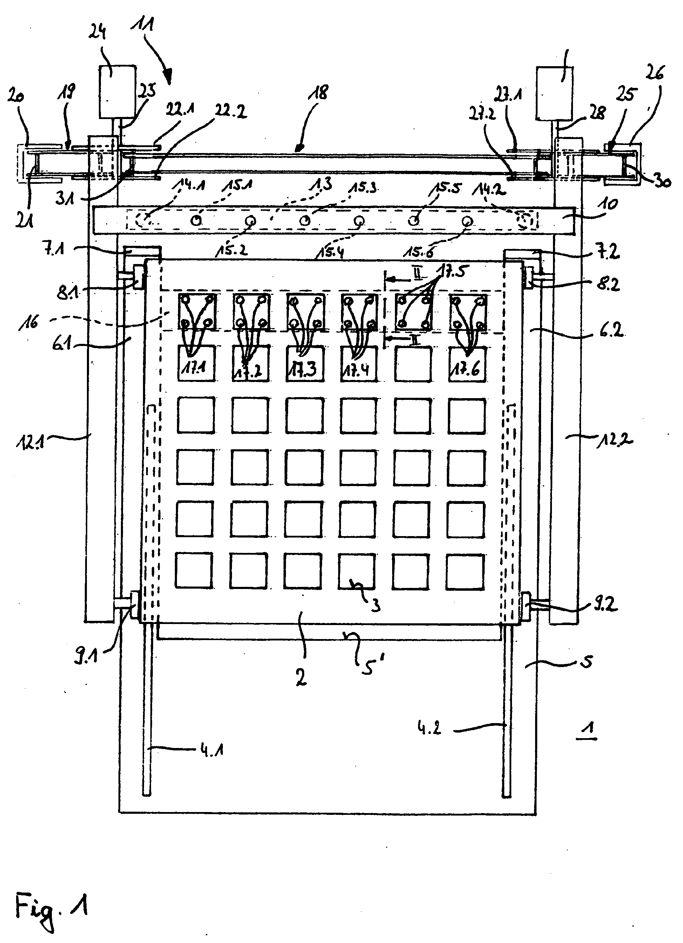

In der Fig. 1 ist eine Vorrichtung 1 zum Trennen von jeweils zwei aufeinander angeordneten scheibenförmigen Elementen bei der Entnahme der scheibenförmigen Elemente aus einem Trägerelement 2 gezeigt. Durch die Vorrichtung 1 werden scheibenförmige Elemente, vorzugsweise Wafer in der Halbleiterfertigung oder bei der Herstellung von photovoltaischen Anlagen, in einem Trägerelement 2 (Carrier) abgelegt. Das Trägerelement 2 weist hierzu mehrere Reihen mit Ausnehmungen 3 auf. In dem dargestellten Ausführungsbeispiel weist das Trägerelement 2 6x6 Ausnehmungen 3 auf. Um den Durchsatz einer Prozessanlage zu erhöhen, ist es vorteilhaft, in die Ausnehmungen 3 jeweils zwei scheibenförmige Elemente einzusetzen. Die beiden in jeweils einer Ausnehmung 3 angeordneten, gleich großen scheibenförmigen Elemente sind dadurch an ihrer jeweils voneinander abgewandten Oberfläche zugänglich. Damit können gleichzeitig zwei scheibenförmige Elemente an jeweils einer Oberfläche bearbeitet werden.

In der Fig. 1 ist eine Draufsicht der erfindungsgemäßen Vorrichtung dargestellt. Beim Bestücken des Trägerelements 2 wird in jede der als Durchgangsöffnung ausgebildeten Ausnehmungen 3 zunächst ein scheibenförmiges Element eingelegt. Die Außengeometrie der Ausnehmungen 3 korrespondiert dabei etwa mit der Außengeometrie eines scheibenförmigen Elements. In der Ausnehmung 3 sind in der Fig. 1 nicht dargestellte Halteelemente am äußeren Umfang vorgesehen, auf denen das untere scheibenförmige Element abgelegt wird. Auf ein unteres in der Ausnehmung 3 abgelegtes scheibenförmiges Element wird anschließend ein weiteres scheibenförmiges Element gelegt.

Wenn das Trägerelement 2 vollständig bestückt ist, wird es aus der in der Fig. 1 dargestellten Vorrichtung 1 herausgefördert. Hierzu sind Transportelemente 4.1 und 4.2 vorgesehen, mit denen das Trägerelement 2 zur Prozessanlage gefördert werden kann.

Die Transportelemente 4.1 und 4.2 sind in einem Grundkörper 5 der erfindungsgemäßen Vorrichtung 1 angeordnet. Der Grundköper 5 weist zudem eine Aussparung 5' auf. Die Aussparung 5' ist so bemessen, dass zu beiden Längsseiten des Grundkörpers 5 jeweils ein Auflagearm 6.1 bzw. 6.2 ausgebildet wird. Die Breite der Aussparung 5' ist etwas schmaler als das Trägerelement 2, so dass das Trägerelement 2 auf den Auflagearmen 6.1 und 6.2 so positioniert werden kann, dass sämtliche in den Ausnehmungen 3 angeordnete scheibenförmige Elemente auch von der Unterseite her zugänglich sind.

Um während des Bestückens des Trägerelements 2 bzw. der Entnahme der scheibenförmigen Elemente aus den Ausnehmungen 3 des Trägerelements 2 eine exakte Positionierung des Trägerelements 2 zu erreichen, sind an den freien Enden der Auflagearme 6.1 und 6.2 Längenanschläge 7.1 bzw. 7.2 angeordnet. Wird das Trägerelement 2 mit Hilfe der Transportelement 4.1 und 4.2 auf dem Grundkörper 5 in Richtung der Längenanschläge 7.1 bis 7.2 gefördert, so definieren die Längenanschläge 7.1 und 7.2 eine Endlage des Trägerelements 2. Zur seitlichen Ausrichtung des Trägerelements 2 sind ein erstes Paar von Positionierschiebern 8.1 und 8.2 und ein zweites Paar von Positionierschiebern 9.1 und 9.2 vorgesehen. Die Positionierschieber 8.1 und 8.2 bzw. 9.1 und 9.2 sind senkrecht zur durch die Transportelemente 4.1 und 4.2 definierte Transportrichtung in der Ebene des Trägerelements 2 bewegbar. Wenn das Trägerelement 2 in seiner Endposition angekommen ist, in der es gegen die Längenanschläge 7.1 und 7.2 gefördert wurde, werden die Positionierschieber 8.1 und 8.2 bzw. 9.1 und 9.2 aufeinander zu bewegt. Dadurch wird das Trägerelement 2 ausgerichtet. Die Positionsschieber 8.1, 8.2 und 9.1 und 9.2 sind vorzugsweise im Bereich der Ecken des rechteckigen Trägerelements 2 angeordnet.

Um die scheibenförmigen Elemente in die Ausnehmungen 3 des Trägerelements 2 zu legen bzw. aus den Ausnehmungen des Trägerelements 2 wieder herauszunehmen, ist ein Transportbalken 10 vorgesehen. Der Transportbalken 10 ist für das Fördern der scheibenförmigen Elemente von einer Fördervorrichtung 11 zu dem Trägerelement 2 bzw. von dem Trägerelement 2 zu der Fördervorrichtung 11 vorgesehen. Über die Fördervorrichtung 11 werden in nachfolgend noch zu beschreibender Weise die scheibenförmigen Elemente sowohl zugeführt als auch die vom Bearbeitungsprozess zurückkommenden scheibenförmigen Elemente abgefördert.

Der Transportbalken 10 erstreckt sich von einer ersten Laufschiene 12.1 zu einer zweiten Laufschiene 12.2. Der Transportbalken 10 ist entlang der Längsausrichtung der Laufschienen 12.1 und 12.2 bewegbar. In dem dargestellten Ausführungsbeispiel, in dem jeweils sechs Ausnehmungen 3 in dem Trägerelement 2 in einer Reihe angeordnet sind, sind die Laufschienen 12.1 und 12.2 senkrecht zu den nebeneinander liegenden Ausnehmungen 3 einer solchen Reihe angeordnet. Durch Bewegen des Transportbalkens 10 auf den Laufschienen 12.1 und 12.2 kann der Transportbalken 10 jeweils über einer solchen Reihe von Ausnehmungen 3 positioniert werden. In dem dargestellten Ausführungsbeispiel lassen sich somit gleichzeitig sechs scheibenförmige Elemente entweder in die Ausnehmungen 3 einsetzen oder aber aus den Aufnehmungen 3 aufnehmen und zurück zu der Fördervorrichtung 11 transportieren.

Die Länge der Laufschienen 12.1 und 12.2 ist so bemessen, dass der Transportbalken 10 bis zu der Fördervorrichtung 11 bzw. zu der in der Fig. 1 zu unterst dargestellten Reihe von Ausnehmungen 3 bewegt werden kann.

An dem Transportbalken 10 ist ein Hebebalken 13 befestigt, wobei der Hebebalken 13 zwischen dem Transportbalken 10 und dem Trägerelement 2 angeordnet ist, wie es in der Fig. 1 durch die gestrichelte Darstellung des Hebebalkens 13 angedeutet ist. Der Abstand zwischen dem Hebebalken 13 und dem Transportbalken 10 ist veränderbar. Hierzu sind eine erste und eine zweite Hebeeinrichtung 14.1 bzw. 14.2 vorgesehen. Mit Hilfe der Hebeeinrichtung 14.1 und 14.2 lässt sich der Abstand zwischen dem Hebebalken 13 und dem Transportbalken 10 variieren. An dem Hebebalken 13 sind Hebe-Saugelemente 15.1 bis 15.6 angeordnet.

Während mit Hilfe des Transportbalkens 10 die Position über eine Reihe von Ausnehmungen 3 des Trägerelements 2 bestimmt wird, lässt sich der Hebebalken 13 mittels der Hebeeinrichtungen 14.1 und 14.2 absenken und somit das jeweils einer Ausnehmung 3 zugeordnete Hebe-Saugelement 15.i in Richtung des entsprechenden scheibenförmigen Elements bzw. der Ausnehmung 3 absenken.

Beim Abheben des oberen von zwei aufeinanderliegenden scheibenförmigen Elementen aus einer Ausnehmung 3 des Trägerelements 2 ist es erforderlich, dass jeweils untere scheibenförmige Element, welches nur auf einem Halteelement aufgrund der Schwerkraft liegt, festzuhalten. Damit wird verhindert, dass durch das Anheben des oberen scheibenförmigen Elements durch das Hebe-Saugelement 15.i das untere scheibenförmige Element aufgrund der Kräfte zwischen den beiden scheibenförmigen Elementen mit angehoben wird. Während der Transportbalken 10 mitsamt dem Hebebalken 13 oberhalb des Trägerelements 2 angeordnet ist, ist zum Halten der jeweils unteren scheibenförmigen Elemente ein Haltevorrichtungskörper 16 vorgesehen, der unterhalb des Trägerelements 2 angeordnet ist. Der Haltevorrichtungskörper 16 erstreckt sich etwa von dem ersten Auflagearm 6.1 zu dem zweiten Auflagearm 6.2 und kann ebenfalls relativ zu dem Trägerelement 2 positioniert werden.

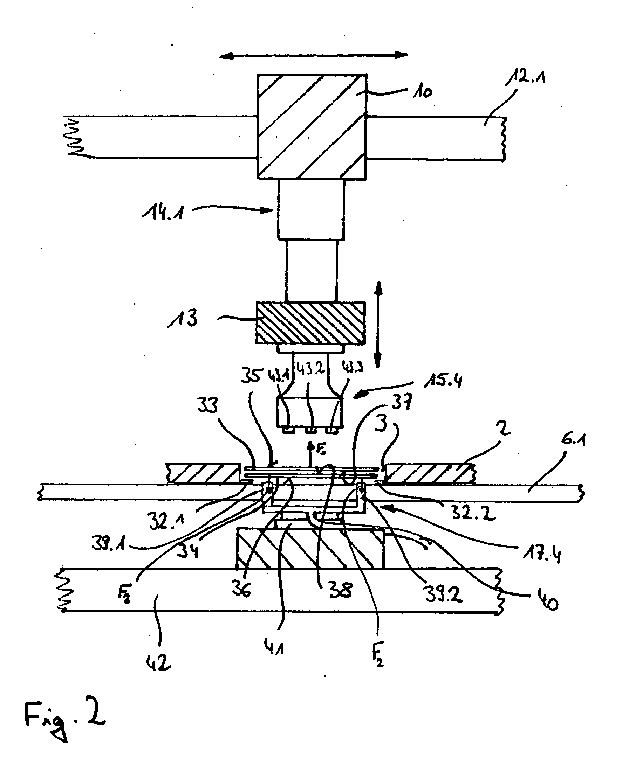

Damit ist ein gleichzeitiges Halten von sechs in einer Reihe angeordneten unteren scheibenförmigen Elementen in den Ausnehmungen 3 des Trägerelements 2 möglich. An dem Haltevorrichtungskörper 16 sind dazu Halte-Saugelemente 17.1 bis 17.6 angeordnet. In dem bevorzugten, dargestellten Ausführungsbeispiel besteht jeweils ein Halte-Saugelement 17.i aus vier Vakuumelementen. Die jeweils vier Vakuumelemente sind so auf dem Haltevorrichtungskörper 16 positioniert, dass sie im Bereich nahe der Ecken der Ausnehmungen 3 angeordnet sind, wenn der Haltevorrichtungskörper 16 unter einer Reihe von Ausnehmungen 3 positioniert ist. Das dargestellte Ausführungsbeispiel zeigt quadratische Ausnehmungen 3, wie sie für quadratische scheibenförmige Elemente vorgesehen sind. Die Erfindung ist jedoch nicht auf eine solche Geometrie beschränkt. Vielmehr können beispielsweise auch runde, rechteckige oder anders mehreckige scheibenförmige Elemente verwendet werden. Die Geometrie der Ausnehmungen 3 in dem Trägerelement 2 korrespondiert jeweils mit der Geometrie der verwendeten scheibenförmigen Elemente. Die Anordnung der einzelnen Vakuumelemente eines Halte-Saugelements 17.i ist an die Geometrie der scheibenförmigen Element angepasst. Insbesondere werden die Vakuumelemente so angeordnet, dass das jeweils untere scheibenförmige Element in seinem äußeren Bereich gehalten wird. Dies wird nachfolgend unter Bezugnahme auf Fig. 2 noch näher erläutert.

Die Zuführung bzw. das Abfördern der scheibenförmigen Elemente erfolgt mittels der Fördervorrichtung 11. Die Fördervorrichtung 11 umfasst ein zentrales Förderelement 18, welches in dem dargestellten Ausführungsbeispiel als Schnurtrieb ausbildet ist. Der Schnurtrieb umfasst zwei parallel zueinander angeordnete Schnüre und ist zumindest so lang, dass sechs scheibenförmige Elemente gleichzeitig auf dem zentralen Förderelement 18 angeordnet sein können. Diese sechs scheibenförmigen Elemente werden dann mit Hilfe des Transportbalkens 10 und der damit verbundenen Hebe-Saugelemente 15.i aufgenommen und in einem Schritt in die Ausnehmungen 3 einer Reihe des Trägerelements 2 abgelegt. In das zunächst leere Trägerelement 2 werden somit zunächst untere scheibenförmige Elemente einer Reihe abgelegt. Auf diesen unteren scheibenförmigen Elementen wird dann jeweils ein zweites scheibenförmiges Element mit Hilfe des Transportbalkens 10 abgelegt.

Bevor die scheibenförmigen Elemente nacheinander auf dem zentralen Förderelement 18 abgelegt werden, werden sie durch ein Eingangs-Förderelement 19 aus einer Kassette 20 entnommen. Eine Vielzahl von scheibenförmigen Elementen sind einzeln auf am Rand angeordneten Auflageflächen in der Kassette 20 angeordnet. Die Kassette 20 weist eine Aussparung im Bereich des Eingangs-Förderelements 19 auf. Durch schrittweises Absenken der Kassette 20 wird das jeweils unterste scheibenförmige Element auf dem Eingangs-Förderelement 19 abgelegt. Das Eingangs-Förderelement 19 ist ebenfalls ein Schnurtrieb und befördert das so auf ihm abgelegte scheibenförmige Element in Richtung zu dem zentralen Förderelement 18. Zur Entnahme des nächsten scheibenförmigen Elements wird die Kassette 20 erneut abgesenkt, bis das nächste scheibenförmige Element auf dem Eingangs-Förderelement 19 zu liegen kommt.

Für den Fall, dass sämtliche in der Kassette 20 angeordneten scheibenförmigen Elemente dieselbe Ausrichtung der zu bearbeitenden Oberfläche besitzen, ist es erforderlich, die in den Ausnehmungen 3 des Trägerelements 2 unten bzw. oben abzulegenden scheibenförmigen Elemente zu wenden. Damit wird sichergestellt, dass die zu bearbeitende zweite Oberfläche des unteren scheibenförmigen Elements nach unten weist und die zu bearbeitende erste Oberfläche des oberen scheibenförmigen Elements nach oben weist. Zum Wenden der scheibenförmigen Elemente ist eine Wendevorrichtung vorgesehen. Die Wendevorrichtung umfasst ein erstes und ein zweites Wenderad 22.1 bzw. 22.2. die Wenderäder 22.1 und 22.2 sind parallel zueinander angeordnet und auf einer gemeinsamen ersten Wendewelle 23 fixiert. In den Wenderädern 22.1 und 22.2 sind Schlitze angeordnet, die sich in radialer Richtung von einem Bereich nahe des Mittelpunkts der Wenderäder 22.1 und 22.2 bis zum äußeren Umfangsrand erstrecken. Die Schlitzbreite ist etwas größer als die Dicke der scheibenförmigen Elemente. Die in dem Wenderad 22.1 und dem Wenderad 22.2 angeordneten Schlitze sind jeweils bezüglich ihrer Winkellage korrespondierend zueinander angeordnet. Damit kann ein scheibenförmiges Element, welches durch das Eingangs-Förderelement 19 aus der Eingangs-Kassette 20 entnommen wird, in ein Paar korrespondierender Schlitze der beiden Wenderäder 22.1 und 22.2 eingeschoben werden. Zum Abheben des scheibenförmigen Elements von dem Eingangs-Förderelement 19 wird die Welle 23 mit Hilfe eines Antriebsmotors um 180° gedreht. Damit wird das scheibenförmige Element gewendet und kommt auf dem zentralen Förderelement 18 zu liegen. Aufgrund der Schlitzbreite, die geringfügig größer ist, als die Dicke des scheibenförmigen Elements, liegt das scheibenförmige Element nun frei auf dem zentralen Förderelement 18. Die Oberseite der Schnurtriebe des Eingangs-Förderelements 19 und des zentralen Förderelements 18 sind auf einem Niveau mit der ersten Wendewelle 23.

Um auch ein Zuführen von nicht gewendeten scheibenförmigen Elementen zu ermöglichen, ist in den Wenderädern 22.1 und 22.2 zumindest ein sich entlang des Durchmessers der Wenderäder erstreckender durchgehender Schlitz vorgesehen. In dem Bereich zwischen den Wenderädern 22.1 und 22.2 ist auch die erste Wendewelle 23 geschlitzt. Damit kann von dem Eingangs-Förderelement 19 ein scheibenförmiges Element unmittelbar in Richtung auf das zentrale Förderelement 18 hin gefördert werden.

Für die aus dem Prozess zurückkommenden scheibenförmigen Elemente ist eine entsprechende Vorrichtung an dem anderen Ende des zentralen Förderelements 18 vorgesehen. Diese Vorrichtung umfasst ein Ausgangs-Förderelement 25 mit Hilfe dessen die bearbeiteten scheibenförmigen Elemente in eine Ausgangs-Kassette 26 abgefördert werden. Mit Hilfe des Ausgangs-Förderelements 25 werden die scheibenförmigen Elemente in die Ausgangs-Kassette 26 hinein transportiert und durch Anheben der Ausgangs-Kassette auf den in der Ausgangskassette ausgebildeten Auflageflächen abgelegt.

Um sämtliche scheibenförmigen Elemente, die aus dem Prozess zurückkommen, wieder einheitlich auszurichten, ist eine zweite Wendevorrichtung vorgesehen, die in ihrem Aufbau der ersten Wendevorrichtung entspricht. Die zweite Wendevorrichtung umfasst daher ein drittes und ein viertes Wenderad 27.1 und 27.2, die auf einer gemeinsamen zweiten Wendewelle 28 angeordnet sind. Die Wenderäder 27.1 und 27.2 werden durch einen zweiten Antriebsmotor 29 bewegt.

Auch die Wenderäder 27.1 und 27.2 weisen zumindest einen durchgehenden Schlitz auf. Ebenso ist in hierzu korrespondierender Winkellage die zweite Wendewelle 28 geschlitzt, so dass auch auf der Ausgangsseite der Fördervorrichtung 11 ein Ablegen der scheibenförmigen Elemente in der Ausgangs-Kassette 26 möglich ist, ohne die scheibenförmigen Elemente zu wenden.

Zum Antreiben der Förderelemente 18, 19 und 21 sind Antriebswellen 21, 30 und 31 sowie nicht dargestellte Antriebsscheiben vorgesehen.

Die Fig.2 zeigte eine vergrößerte Detailansicht entlang des Schnitts II-II zur Erläuterung des Trennens der aufeinanderliegenden scheibenförmigen Elemente bei der Entnahme der scheibenförmigen Elemente aus einer Ausnehmung 3 eines Trägerelements 2.

In der Darstellung der Fig. 2 ist der Transportbalken 10 über eine Reihe von sechs Ausnehmungen 3 des Trägerelements 2 positioniert.

Wie es bereits erläutert wurde, ist der Transportbalken 10 über eine Hebeeinrichtung 14.1 mit dem Hebebalken 13 verbunden. An dem Hebebalken 13 ist ein Hebe-Saugelement 15.4 angeordnet. Durch Längenänderung der Hebeeinrichtung 14.1, die beispielsweise ein pneumatisch betätigter Hubzylinder ist, kann der Abstand zwischen dem Transportbalken 10 und dem Hebebalken 13 variiert und damit das Hebe-Saugelement 15.4 in Richtung auf das Trägerelement 2 hin abgesenkt werden. Die Ausführungen bezüglich der Fig. 2 betreffen eine einzelne Ausnehmung 3 sowie die darin angeordneten zwei scheibenförmigen Elemente 33 und 34. Die Ausführungen treffen jedoch in identischer Weise auf sämtliche in den Ausnehmungen 3 angeordneten scheibenförmige Elemente zu.

Wie es bereits erläutert wurde, werden in einer Ausnehmung 3 zwei scheibenförmige Elemente 33 und 34 aufeinander abgelegt. Zunächst wird das untere scheibenförmige Element 34 in die Ausnehmung 3 gelegt. Um das untere scheibenförmige Element 34 in der Ausnehmung 3 zu halten, sind am Rand der Ausnehmung 3 Halteelemente 32.1 und 32.2 vorgesehen. Die Halteelemente 32.1 und 32.2 können beispielsweise kleine Drahtbügel sein, welche jeweils im Bereich nahe der Ecken an dem Trägerelement 2 in der Ausnehmung angeordnet sind und in Richtung der Mitte der Ausnehmungen 3 hervorstehen. Auf das untere scheibenförmige Element 34 wird dann ein oberes scheibenförmiges Element 33 gelegt. Die zu bearbeitenden Flächen sind eine erste Oberfläche 35 des oberen scheibenförmigen Elements 33 sowie eine zweite Oberfläche 36 des zweiten scheibenförmigen Elements 34. Eine zweite Oberfläche 37 des oberen scheibenförmigen Elements 33 liegt dagegen auf einer ersten Oberfläche 38 des unteren scheibenförmigen Elements 34 flach auf.

Zum Abheben des oberen scheibenförmigen Elements 33 wird das Hebe-Saugelement 15.4 in Richtung auf die erste Oberfläche 35 des oberen, ersten scheibenförmigen Elements 33 abgesenkt. In dem dargestellten Ausführungsbeispiel ist das Hebe-Saugelement 15.4 ein sog. Bernoulli-Sauger. Wenn das Hebe-Saugelement 15.4 nahe der Oberfläche 35 des oberen scheibenförmigen Elements 33 angeordnet ist, wird eine erste Unterdruckkraft an der ersten Oberfläche 35 des oberen scheibenförmigen Elements 33 erzeugt. Das erste scheibenförmige Element 33 wird dadurch in Anlage an beispielsweise drei über einen Umfangskreis verteil angeordnete Anlageelementen 43.1 bis 43.3 an der Unterseite des Bernoulli-Saugelements gehalten. Diese erste Unterdruckkraft wird durch die Strömung des Fluids, das aus dem Bernoulli-Sauger ausritt, erzeugt. Die erforderliche Luftmenge wird durch eine Pumpe erzeugt und über ein der besseren Übersichtlichkeit wegen nicht dargestelltes Leitungssystem dem Bernoulli-Sauger zugeführt. Zur Erzeugung der ersten Unterdruckkraft auf die erste Oberfläche 35 des oberen scheibenförmigen Elements 33 wird vorzugsweise ein einzelner Bernoulli-Sauger als Hebe-Saug-Element 15.4 vorgesehen. Dieser wird mittig über der ersten Oberfläche 35 des oberen scheibenförmigen Elements 33 positioniert. Die Kraft greift somit in einem inneren Bereich der ersten Oberfläche 35 an und wirkt in Richtung auf das Hebe-Saug-Element 15.4.

Um das versehentliche gleichzeitige Anheben des an dem oberen scheibenförmigen Element 33 haftenden unteren scheibenförmigen Elements 34 zu verhindern, ist unterhalb des Trägerelements 2 eine Haltevorrichtung vorgesehen. Die Haltevorrichtung umfasst in dem dargestellten Ausführungsbeispiel der Fig. 2 ein Halte-Saugelement 17.4. Das Halte-Saugelement 17.4 besteht vorzugsweise aus einer Mehrzahl von Vakuumelementen 39.1 und 39.2. Die Vakuumelemente 39.1 und 39.2 sind bei der Verwendung quadratischer oder rechteckiger scheibenförmiger Elemente vorzugsweise in dem Bereich der Ecken der scheibenförmigen Elemente angeordnet. Die Vakuumelemente 39.1 und 39.2 sowie die beiden weiteren, in der Fig. 2 nicht sichtbaren Vakuumelemente, sind mit einem Unterdruckschlauch 40 verbunden und gemeinsam über eine Hubvorrichtung 41 bewegbar. Damit können die Vakuum-Elemente 39.1 und 39.2 der zweiten Oberfläche 36 des unteren scheibenförmigen Elements 34 angenähert werden.

Während durch das Hebe-Saugelement 15.4 im dargestellten Beispiel in einem inneren Bereich der ersten Oberfläche 35 des scheibenförmigen Elements 33 eine erste Unterdruckkraft F₁ zum Anheben des oberen scheibenförmigen Elements 33 erzeugt wird, wird durch das Halte-Saug-Element 17.4 an der zweiten Oberfläche 36 eine zweite Unterdruckkraft F₂ als Haltekraft in dem äußeren Bereich der zweiten Oberfläche 36 erzeugt. Damit ist die Kraftverteilung auf die erste Oberfläche 35 des oberen scheibenförmigen Elements und die zweite Oberfläche 36 des unteren scheibenförmigen Elements 34 unterschiedlich. In der Fig. 2 wird dies stark vereinfacht durch die Kraftpfeile F₁ und F₂ dargestellt. In Folge dessen wird sich ein Vakuum zwischen der zweiten Oberfläche 37 des oberen scheibenförmigen Elements 33 und der ersten Oberfläche 38 des unteren scheibenförmigen Elements 34 nicht oder nur in reduziertem Maß ausbilden.

Die Verwendung von einem Bernoulli-Sauger als Hebe-Saug-Element 15.4 und den vier Vakuumelementen, von denen in der Fig. 2 lediglich zwei Vakuumelemente 39.1 und 39.2 zu sehen sind, als Halte-Saugelement 17.4 ist lediglich beispielhaft zu verstehen. Im Sinne der Erfindung ist es von besonderer Bedeutung, dass die Kraftverteilung, mit der an der ersten Oberfläche 35 des oberen scheibenförmigen Elements 33 eine zum Abheben des oberen scheibenförmigen Elements 33 erforderliche erste Unterdruckkraft F₁ erzeugt wird, sich von der Kraftverteilung, die durch die Haltevorrichtung als zweite Unterdruckkraft F₂ erzeugt wird, unterscheidet. Hierdurch wird eine gegengleiche Verformung des oberen scheibenförmigen Elements 33 und des unteren scheibenförmigen Elements 34 verhindert. Dabei werden jeweils die Hebekraft auf das obere scheibenförmige Element 33 und die Haltekraft auf das untere scheibenförmige Element 34 durch eine erste Unterdruckkraft F₁ auf die erste Oberfläche 35 des oberen scheibenförmigen Elements 33 bzw. durch eine zweite Unterdruckkraft F₂ auf die zweite Oberfläche 36 des zweiten, unteren scheibenförmigen Elements 34 erzeugt. Im Unterschied zu dem dargestellten Ausführungsbeispiel der Fig. 1 und 2 können sowohl die erste Unterdruckkraft F₁ als auch die zweite Unterdruckkraft F₂ auch jeweils durch Bernoulli-Saugelemente oder jeweils durch Vakuumelemente erzeugt werden. Vorzugsweise kommt jedoch zumindest für die Hebevorrichtung ein Bernoulli-Saugelement zum Einsatz, um das Ansaugen von Schmutzpartikeln zu verhindern.

Um die Haltevorrichtung korrekt unterhalb einer Reihe von Ausnehmungen 3 des Trägerelements 2 zu positionieren, wirkt der Haltevorrichtungskörper 16 mit einem zweiten Schienensystem 42 verschiebbar zusammen. Die Verschiebung des Transportbalkens 10 auf den Laufschienen 12.1 und 12.2 sowie des Hebebalkens 16 auf dem zweiten Schienensystem 42 kann unabhängig voneinander erfolgen. Das Erzeugen eines Vakuums für die Vakuum-Elemente 39.1 und 39.2 erfolgt vorzugsweise getaktet ebenso wie das Durchströmen der Bernoulli-Sauger. Damit wird ein Unterdruck in den VakuumElementen 39.1 und 39.2 jeweils nur dann erzeugt, wenn durch die Hebevorrichtung mittels des Hebe-Saugelements 15.4 das obere scheibenförmige Element 33 von dem unteren scheibenförmigen Element 34 abgehoben wird. Die Taktung des Hebe-Saugelements 15.4 wird durch das Aufnehmen eines Element bzw. das Ablegen des gehaltenen Elements in einer Ausnehmung oder auf dem zentralen Förderelement 18 bestimmt .

In dem bevorzugten dargestellten Ausführungsbeispiel, in dem die Hebevorrichtung für jedes abzuhebende scheibenförmige Element einen Bernoulli-Sauger aufweist, erzeugt eine erste Unterdruckkraft F₁ in einem inneren Bereich der ersten Oberfläche 35 des oberen scheibenförmigen Elements 33 eine Kraft zum Anheben und Halten des scheibenförmigen Elements 33 bzw. 34. An der zweiten Oberfläche 36 des zweiten scheibenförmigen Elements 34 wird dagegen in einem äußeren Bereich also in der Nähe des Randes des unteren scheibenförmigen Elements 34 eine zweite Unterdruckkraft F₂ erzeugt. Ebenso ist es jedoch möglich, die erste Unterdruckkraft F₁ zum Abheben des oberen scheibenförmigen Elements 33 im Randbereich des oberen scheibenförmigen Elements 33 zu erzeugen. Umgekehrt wird dann die Haltekraft in einem inneren Bereich der zweiten Oberfläche 36 des zweiten scheibenförmigen Elements 34 erzeugt. Denkbar ist es ebenso, lediglich die Kraftverteilung der ersten Unterdruckkraft F₁ und der zweiten Unterdruckkraft F₂ unterschiedlich zu wählen, wobei jedoch zum Erzeugen der jeweiligen Unterdruckkräfte F₁, F₂ sowohl für die Haltevorrichtung als auch für die Hebevorrichtung Bernoulli-Saugelemente zum Einsatz kommen. Zum Erzeugen der unterschiedlichen Kraftverteilungen werden dann jedoch für die Hebevorrichtung bzw. für die Haltevorrichtung eine unterschiedliche Anzahl von Saugelementen verwendet. Dies kann auch durch Verwendung von Vakuumelementen sowohl für die Hebevorrichtung als auch für die Haltevorrichtung erfolgen.

Die Erfindung ist nicht auf das vorbeschriebene Ausführungsbeispiel beschränkt. Insbesondere sind Anpassungen der Hebevorrichtung und der Haltevorrichtung an unterschiedliche zu verwendende Trägersysteme denkbar. Insbesondere ist die Erfindung nicht auf das Entnehmen lediglich einer Reihe von Elementen aus Ausnehmungen des Trägerelements 2 beschränkt. Vielmehr können auch aus mehreren Reihen von Ausnehmungen die oberen scheibenförmigen Elemente 33 entnommen werden, bevor sie zu der Fördervorrichtung 11 transportiert werden. Ferner können die einzelnen Hebe-Saugelemente 15.i ebenso wie die einzelnen Halte-Saugelemente 17.i durch individuelle Hebeeinrichtungen bezüglich ihres Abstands zu den scheibenförmigen Elementen bewegt werden.

## Patentansprüche

1. Vorrichtung zum Trennen von zwei aufeinander angeordneten scheibenförmigen Elementen (33, 34) bei der Entnahme der scheibenförmigen Elemente (33, 34) aus einem Trägerelement (2) mit zumindest einer Hebevorrichtung (15.i) zum Abheben eines ersten, oberen von zwei aufeinander angeordneten scheibenförmigen Elementen (33) und einer Haltevorrichtung (17.i) zum Halten des zweiten, unteren scheibenförmigen Elements (36), wobei durch die Hebevorrichtung (15.i) eine erste Unterdruckkraft (F₁) auf eine erste Oberfläche (35) des ersten scheibenförmigen Elements (33) erzeugbar ist und durch die Haltevorrichtung (17.i) eine zweite Unterdruckkraft (F₂) auf eine zweite Oberfläche (36) des zweiten scheibenförmigen Elements (34) erzeugbar ist, die von der ersten Oberfläche (35) des ersten scheibenförmigen Elements (33) abgewandt ist, wobei die Hebevorrichtung (15.i) und die Haltevorrichtung (17.i) so ausgebildet sind, dass die durch die erste Unterdruckkraft (F₁) an der ersten Oberfläche (35) des ersten scheibenförmigen Elements (33) erzeugte Kraftverteilung sich in ihrer Geometrie von der durch die zweite Unterdruckkraft (F₂) an der zweiten Oberfläche (36) des zweiten scheibenförmigen Elements (34) erzeugten Kraftverteilung unterscheidet.

2. Vorrichtung nach Anspruch 1,
**dadurch gekennzeichnet,**
**dass** die Hebevorrichtung (15.i) eine von der Haltevorrichtung (17.i) unterschiedliche Anzahl von Saugelementen umfasst.

3. Vorrichtung nach Ansprüche 1 oder 2,
**dadurch gekennzeichnet,**
**dass** zumindest die Hebevorrichtung (15.i) zumindest ein Bernoulli-Saugelement aufweist.

4. Vorrichtung nach einem der Ansprüche 1 bis 3,
**dadurch gekennzeichnet,**
**dass** die Haltevorrichtung (17.i) zumindest ein Vakuum-Saugelement aufweist.

5. Vorrichtung nach einem der Ansprüche 1 bis 4,
**dadurch gekennzeichnet,**
**dass** die Hebevorrichtung (15.i) so eingerichtet ist, dass die erste Unterdruckkraft (F₁) in einem inneren Bereich des ersten scheibenförmigen Elements (33) erzeugt wird und
**dass** die Haltevorrichtung (17.i) so eingerichtet ist, dass die zweite Unterdruckkraft (F₂) in einem äußeren Bereich des zweiten scheibenförmigen Elements (34) erzeugt wird.

6. Vorrichtung nach einem der Ansprüche 1 bis 4,
**dadurch gekennzeichnet,**
**dass** die Hebevorrichtung (15.i) so eingerichtet ist, dass die erste Unterdruckkraft (F1) in einem äußeren Bereich des ersten scheibenförmigen Elements (33) erzeugt wird und
**dass** die Haltevorrichtung (17.i) so eingerichtet ist, dass die zweite Unterdruckkraft (F2) in einem inneren Bereich des zweiten scheibenförmigen Elements (34) erzeugt wird.

## Claims

1. Device for separating two disc-shaped elements (33, 34) arranged one on top of the other during removal of the disc-shaped elements (33, 34) from a carrier element (2), having at least one lifting device (15.i) for lifting a first, upper disc-shaped element (33) of two disc-shaped elements arranged one on top of the other and a holding device (17.i) for holding the second, lower disc-shaped element (36), a first negative-pressure force (F₁) being producible by the lifting device (15.i) on a first surface (35) of the first disc-shaped element (33) and a second negative-pressure force (F₂) being producible by the holding device (17.i) on a second surface (36) of the second disc-shaped element (34) facing away from the first surface (35) of the first disc-shaped element (33), the lifting device (15.i) and the holding device (17.i) being designed such that the force distribution produced by the first negative-pressure force (F₁) on the first surface (35) of the first disc-shaped element (33) differs in its geometry from the force distribution produced by the second negative-pressure force (F₂) on the second surface (36) of the second disc-shaped element (34).

2. Device according to Claim 1,
**characterised**
**in that** the lifting device (15.i) comprises a different number of suction elements from the holding device (17.i).

3. Device according to Claim 1 or 2,
**characterised**
**in that** at least the lifting device (15.i) has at least one Bernoulli suction element.

4. Device according to one of Claims 1 to 3,
**characterised**
**in that** the holding device (17.i) has at least one vacuum suction element.

5. Device according to one of Claims 1 to 4,
**characterised**
**in that** the lifting device (15.i) is set up such that the first negative-pressure force (F₁) is produced in an inner region of the first disc-shaped element (33) and
**in that** the holding device (17.i) is set up such that the second negative-pressure force (F₂) is produced in an outer region of the second disc-shaped element (34).

6. Device according to one of Claims 1 to 4,
**characterised**
**in that** the lifting device (15.i) is set up such that the first negative-pressure force (F1) is produced in an outer region of the first disc-shaped element (33) and
**in that** the holding device (17.i) is set up such that the second negative-pressure force (F2) is produced in an inner region of the second disc-shaped element (34).

## Revendications

1. Dispositif de séparation de deux éléments circulaires (33,34) agencés l'un sur l'autre, lors de l'extraction des éléments circulaires (33,34) d'un élément de support (2) avec au moins un dispositif de levage (15.i) pour le relavage d'un premier élément supérieur (33) de deux éléments circulaires agencés l'un sur l'autre et un dispositif de retenue (17.i) pour retenir le deuxième élément circulaire inférieur (36), où peut être produite par le dispositif de levage (15.i) une première force de dépression (F₁) sur une première surface (35) du premier élément circulaire (33), et par le dispositif de retenue (17.i) une deuxième force de dépression (F₂) peut être produite sur une deuxième surface (36) du deuxième élément circulaire (34), qui est éloignée de la première surface (35) du premier élément circulaire (33), où le dispositif de levage (15.i) et le dispositif de retenue (17.i) sont réalisés de telle sorte que la répartition de la force produite par la première force de dépression (F₁) à la première surface (35) du premier élément circulaire (33) se distingue dans sa géométrie de la répartition de la force produite par la deuxième force de dépression (F₂) à la deuxième surface (36) du deuxième élément circulaire (34).

2. Dispositif selon la revendication 1, **caractérisé en ce que** le dispositif de levage (15.i) comprend un nombre d'éléments d'aspiration qui diffère de celui du dispositif de retenue (17.i).

3. Dispositif selon la revendication 1 ou 2, **caractérisé en ce qu'**au moins le dispositif de levage (15.i) présente au moins un élément d'aspiration Bernoulli.

4. Dispositif selon l'une des revendications 1 à 3, **caractérisé en ce que** le dispositif de retenue (17.i) présente au moins un élément d'aspiration à vide.

5. Dispositif selon l'une des revendications 1 à 4, **caractérisé en ce que** le dispositif de levage (15.i) est conçu de telle sorte que la première force de dépression (F₁) est produite dans une zone intérieure du premier élément circulaire (33) et **en ce que** le dispositif de retenue (17.i) est conçu de façon que la deuxième force de dépression (F₂) soit produite dans une zone extérieure du deuxième élément circulaire (34).

6. Dispositif selon l'une des revendications 1 à 4, **caractérisé en ce que** le dispositif de levage (15.i) est conçu de façon que la première force de dépression (F₁) soit produite dans une zone extérieure du premier élément circulaire (33) et **en ce que** le dispositif de retenue (17.i) est conçu de façon que la deuxième force de dépression (F₂) soit produite dans une zone intérieure du deuxième élément en forme de disque (34).
